Europäisches Patentamt

European Patent Office

Office européen des brevets

(11) Publication number: **0 173 386**
**B1**

(12) **EUROPEAN PATENT SPECIFICATION**

(45) Date of publication of patent specification: 03.05.89

(51) Int. Cl.⁴: **H 01 L 27/10**

(21) Application number: **85201288.9**

(22) Date of filing: **09.08.85**

(54) CMOS RAM with merged bipolar transistor.

(30) Priority: **22.08.84 US 643580**

(43) Date of publication of application:
**05.03.86 Bulletin 86/10**

(45) Publication of the grant of the patent:
**03.05.89 Bulletin 89/18**

(84) Designated Contracting States:
**DE FR GB**

(56) References cited:
**EP-A-0 065 269**
**DE-A-2 547 220**
**FR-A-2 295 527**

**ELECTRONICS INTERNATIONAL, vol. 53, no.
24, 6th November 1980, pages 145-148,
McGraw Hill, New York, US; T. OHZONE: "64-K
static RAM surrounds n-MOS cells with C-MOS
circuits"**

(73) Proprietor: **N.V. Philips' Gloeilampenfabrieken**
**Groenewoudseweg 1**
**NL-5621 BA Eindhoven (NL)**

(72) Inventor: **Simmons, George Houston**
**INT. OCTROOIBUREAU B.V. Prof.Holstlaan 6**
**NL-5656 AA Eindhoven (NL)**

(74) Representative: **Houbiers, Ernest Emile Marie**
**Gerlach et al**
**INTERNATIONAAL OCTROOIBUREAU B.V. Prof.
Holstlaan 6**
**NL-5656 AA Eindhoven (NL)**

Courier Press, Leamington Spa, England.

## Description

This invention relates to an integrated circuit CMOS static RAM cell, comprising, a substrate of a first conductivity type semiconductor material;

a region of a second conductivity type semiconductor material located in said substrate and forming a well therein having a surface;

a plurality of regions of said first conductivity type semiconductor material located in said well, forming source and drain zones of field effect transistors which form two data storage transistors with cross-coupled gate electrodes of the memory cell.

Such a memory cell is known e.g. from EP—A—0,020,113.

Complementary metal oxide semiconductor (CMOS) technology is typically employed to fabricate static random access memory (RAM) devices, both N-channel and P-channel memory devices have been designed, in the past, however, in particular P-channel cells have for the most part been considered too slow for practical purposes.

It is an object of this invention to provide a CMOS static RAM cell, in particular a CMOS N-well, P-channel static RAM cell that is faster than previous cells.

An integrated circuit CMOS static RAM cell according to the invention is characterized in that there are six regions of said first conductivity type semiconductor material located in said well forming six pockets therein arranged in two sets of three pockets each, the first and third pocket of each set being separated from the second along the surface of said well by sections of said well material comprising four in number;

a thin oxide layer located on said four sections of said well material forming insulator layers;

gate electrodes located on said four insulator layers;

said gate electrodes and said six pockets comprising four field effect transistors, said two data storage transistors and two access transistors;

one pocket in each set having a region of said second conductivity type semiconductor material located in it, each said region in a pocket comprising the emitter of a bipolar transistor with the pocket it is located in comprising the base and said well comprising the collector of said associated bipolar transistor.

One of the features of the invention is the provision of merged NPN bipolar transistors for each cell, which enhances the operation of the cell. These NPN-transistors may be fabricated during conventional source/drain diffusions, and by diffusing an N-region into an inherent P-region of the cell. The provision of the NPN transistors consequently does not increase the size of the cell.

Other objects, features and advantages of the invention will be apparent from the following description and appended claims when considered in conjunction with the accompanying drawing in which:

Figure 1 is a cross-section of the memory cell of the invention;

Figure 2 is a cross-section of a PNP transistor used in an array of memory cells of the type shown in Figure 1;

Figure 3 is a circuit diagram of the cell shown in Figure 1 together with two PNP transistors such as that shown in Figure 2.

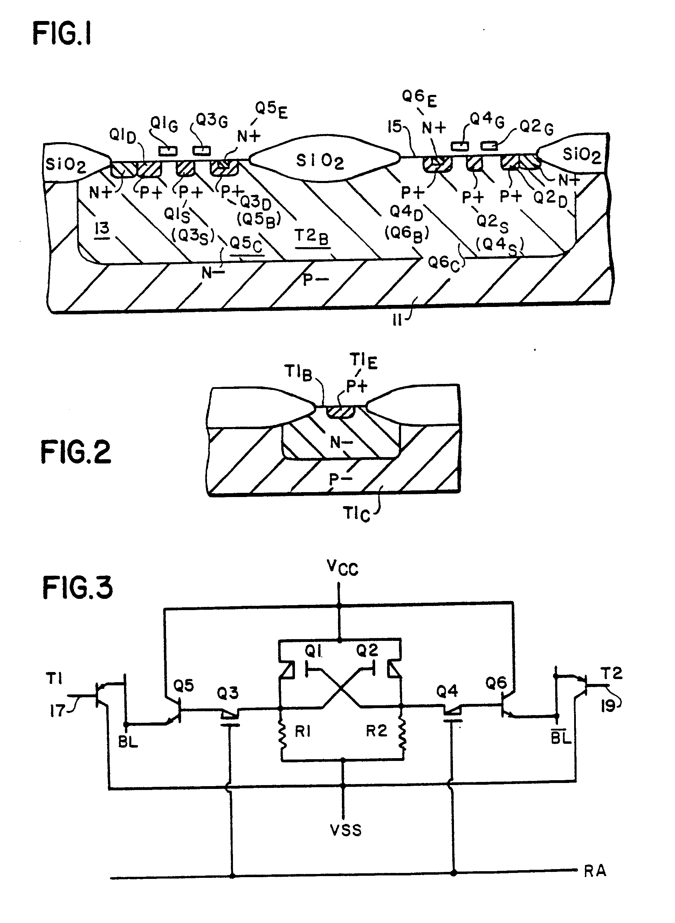

Referring now to the drawing, there is shown in Figure 1, a substrate 11 of a first conductivity or P-type semiconductor material. Located in the substrate is a region of a second conductivity or N-type semiconductor material forming a well 13 therein having a surface 15. Six regions of P-type semiconductor material are located in well 15. These are identified as $Q1_D$, $Q1_S$ ($Q3_S$), $Q3_D$ ($Q5_B$), $Q2_D$, $Q2_S$ ($Q4_S$) and $Q4_D$ ($Q6_B$). These regions form six pockets in the well and are arranged in two sets of three pockets each. The first pockets $Q1_D$ and $Q2_D$ and the third pockets $Q4_D$ ($Q6_B$) and $Q3_D$ ($Q5_B$) of each set are separated from the second pocket $Q1_S$ ($Q3_S$) and $Q2_S$ ($Q4_S$) along surface 15 of the well by sections of the well material comprising four in number. A thin oxide layer (not shown) is formed on the four separating sections of the well. These form insulator layers. Gate electrodes of a polysilicon material forming gates $Q1_G$, $Q2_G$, $Q3_G$ and $Q4_G$ are formed on the four insulator layers.

Diffused into the third pocket of each set is a region of N-type semiconductor material. These comprise the emitters $Q5_E$ and $Q6_E$ of two bipolar transistors of which pockets $Q5_B$ and $Q6_B$ form the bases and the N-type well forms the collectors.

The six regions of P-type material in well 13 and the four gates comprise four field effect transistors Q1, Q2, Q3 and Q4 which are connected as shown in Figure 3. Also shown in Figure 3 are two bipolar PNP-type transistors T1 and T2. Each of these is formed on the substrate, as shown in Figure 2 for transistor T1, by diffusing an N well $T1_B$ into the substrate to form the base of its associated transistor. The emitter of the associated transistor $T1_E$ is formed by the diffusion of a P-type material into the N-well. The substrate comprises the collector $T1_C$ of the associated transistor. Resistors R1 and R2 (not shown in Figure 1) may be formed as film devices on substrate 11 in any well known manner.

In operation if the cell shown in Figure 3 is to be read, line RA is brought low to turn on transistors Q3 and Q4. Assume the cell to be in such condition that transistor Q1 is charged and transistor Q2 is discharged. When transistor Q3 turns on, transistor Q1 will not conduct and voltage $V_{cc}$ is not applied to the base of transistor Q5. As a result, that transistor remains in the off condition and line BL remains low. Since transistor Q2 is discharged when transistor Q4 turns on voltage $V_{cc}$ is applied to the base of transistor Q6 through transistors Q2 and Q4 and transistor Q6 is turned on. As a consequence, Voltage $V_{cc}$ is applied to line BL to signify that transistor Q2 is uncharged.

To demonstrate a writing operation assume transistor Q1 is conductive and transistor Q2 is not-conductive. The cell is written into in order to reverse its condition and cause transistor Q1 to be not-conductive and transistor Q2 to be conductive. In order to do this, line RA again goes low to turn on transistors Q3 and Q4. In order to discharge transistor Q1, an appropriate low voltage is applied along line 17 to the base of transistor T1 to cause it to turn on. This holds line B1 at the low potential of $V_{ss}$. At the same time an appropriate voltage is applied along line 19 to the base of transistor T2 to maintain it in its off condition.

The low voltage on line 17 causes BL to go to low potential $V_{ss}$ since emitter voltage of T1 differs slightly from its collector voltage $V_{ss}$. With Q3 (and Q4) turned on, the base voltage of Q5 is one $V_{be}$, or about 0.7 V above $V_{ss}$. The voltage of the source of Q3 is just slightly greater than its drain voltage. As a result, the gate voltage of Q2 is around 1 Volt, i.e. $1V_{be}$ plus small voltage drops across T1 and Q3 above $V_{ss}$. Q1 and Q2 are assumed to be enhancement FET's with threshold voltages of about 1V. Q2 thus will turn on when its gate voltage drops more than 1V below $V_{cc}$. Assuming $V_{cc}$ is at least 2V (e.g. 5V) above $V_{ss}$, applying low voltage on line 17 causes Q2 to turn on because its gate voltage falls to at least 1V below $V_{cc}$ since the gate voltage of Q2 goes around 1V above $V_{ss}$. As Q2 turns on, its drain voltage rises to pull-up the gate voltage of Q1 and causes Q1 to turn off.

As those skilled in the art will appreciate, the arrangement described herein is for illustrative purposes and is not to be considered restrictive.

Although the invention if of particular importance for P-channel devices, important advantages may be obtained also in N-channel devices wherein Q1, Q2, Q3 and Q4 are provided as N-channel FET's in a P-type well, and wherein the transistors Q5 and Q6 are formed by merged PNP-transistors.

## Claims

1. An integrated circuit CMOS static RAM cell, comprising a substrate of a first conductivity type semiconductor material;

a region of a second conductivity type semiconductor material located in said substrate and forming a well therein having a surface;

a plurality of regions of said first conductivity type semiconductor material located in said well, forming source and drain zones of field effect transistors which form two data storage transistors with cross-coupled gate electrodes of the memory cell, characterized in that there are six of said regions of said first conductivity type semiconductor material located in said well forming six pockets therein arranged in two sets of three pockets each, the first and third pocket of each set being separated from the second along the surface of said well by sections of said well material comprising four in number;

a thin oxide layer located on said four sections of said well material forming insulator layers;

gate electrodes located on said four insulator layers;

said gate electrodes and said six pockets comprising four field effect transistors, said two data storage transistors and two access transistors;

one pocket in each set having a region of said second conductivity type semicondcutor material located in it, each said region in a pocket comprising the emitter of a bipolar transistor with the pocket it is located in comprising the base and said well comprising the collector of said associated bipolar transistor.

2. An integrated circuit CMOS static RAM cell as in claim 1, wherein said first conductivity type semiconductor material is P-type material and said second type semiconductor material is N-type material.

3. An integrated circuit CMOS static RAM cell as in claim 2, wherein the source regions of said data storage transistors are connected together and the drain region of each is connected to the gate electrode of the other.

4. An integrated circuit CMOS static RAM cell as in claim 3, wherein the source region of one said access transistors is connected to the gate electrode of one data storage transistor and the source region of the other access transistor is connected to the gate electrode of the other data storage transistor and wherein the drain region of one of said access transistors is connected to the base of one of said bipolar transistors and the drain region of the other access transistor is connected to the base of the other bipolar transistor.

5. An integrated circuit CMOS static RAM cell as in claim 4, wherein the collectors of said bipolar transistors are connected together and the emitters are the outputs of said memory cell.

6. An integrated circuit CMOS static RAM cell as in claim 5, including two PNP-type transistors, the emitters of one connected with the emitter of one of said bipolar transistors and the emitter of the other connected with the emitter of the other bipolar transistor, the collectors of the PNP-transistors being connected to a low voltage, the bases of said PNP-transistors serving for receiving appropriate writing signals.

## Patentansprüche

1. Integrierte Schaltung einer CMOS statischen RAM-Zelle mit:

einem Substrat aus einem Halbleitermaterial eines ersten Leitungstyps;

einem Gebiet aus einem Halbleitermaterial eines zweiten Leitungstyps, das in dem genannten Substrat liegt und darin eine Mulde mit einer Oberfläche bildet;

einer Anzahl Gebiete aus dem Halbleitermaterial des genannten ersten Leitungstyps, die in der genannten Mulde liegen und Source- und Drain-Zonen von Feldeffekttransistoren bilden, die zwei Datenspeichertransistoren mit quergekoppelten Gate-Elektroden der Speicherzelle bilden, dadurch gekennzeichnet, dass sechs der genannten Gebiete aus dem genannten Halbleitermaterial des ersten Leitungstyps in der genannten Mulde liegen und darin sechs Taschen bilden, die in zwei Sätze zu je drei Taschen gegliedert sind, wobei die erste und dritte Tasche jedes Satzes längs der Oberfläche der genannten Mulde durch vier Teile aus dem genannten Muldenmaterial von der zweiten Tasche getrennt sind;

eine dünne Oxidschicht auf den vier Teilen aus dem genannten Muldenmaterial vorhanden ist und eine Isolierschicht bildet;

Gate-Elektroden auf den vier Isolierschichten vorhanden sind;

diese Gate-Elektroden und diese sechs Taschen vier Feldeffekttransistoren, die genannten zwei Datenspeichertransistoren und zwei Zugrifftransistoren, aufweisen;

eine Tasche in jedem Satz ein Gebiet aus dem genannten Halbleitermaterial des zweiten Leitungstyps enthält, wobei jedes genannte Gebiet in einer Tasche den Emitter eines Bipolartransistors aufweist, die Tasche, in der er vorhanden ist, die Basis aufweist und die genannte Mulde den Kollektor des genannten zugeordneten Bipolartransistors aufweist.

2. Integrierte Schaltung einer CMOS statischen RAM-Zelle nach Anspruch 1, dadurch gekennzeichnet, dass das genannte Halbleitermaterial vom ersten Leitungstyp P-leitendes Material ist und das genannte Halbleitermaterial vom zweiten Leitungstyp N-leitendes Material ist.

3. Integrierte Schaltung einer CMOS statischen RAM-Zelle nach Anspruch 2, dadurch gekennzeichnet, dass die Source-Gebeite der genannten Datenspeichertransistoren miteinander verbunden sind und das Drain-Gebiet jedes Transistors mit der Gate-Elektrode das anderen Transistors verbunden ist.

4. Integrierte Schaltung einer CMOS statischen RAM-Zelle nach Anspruch 3, dadurch gekennzeichnet, dass die Source-Gebiet eines der genannten Zugriffstransistoren mit der Gate-Elektrode eines Datenspeichertransistors und das Source-Gebiet des anderen Zugriffstransistors mit der Gate-Elektrode das anderen Datenspeichertransistors verbunden ist und dass das Drain-Gebiet eines der genannten Zugriffstransistoren mit der Basis eines der genannten Bipolartransistoren und das Drain-Gebiet des anderen Zugriffstransistors mit der Basis des anderen Bipolartransistors verbunden ist.

5. Integrierte Schaltung eines CMOS statischen RAM-Zelle nach Anspruch 4, dadurch gekennzeichnet, dass die Kollektor-Elektroden der genannten Bipolartransistoren miteinander verbunden sind und die Emitter-Elektroden die Ausgänge der genannten Speicherzelle bilden.

6. Integrierte Schaltung einer CMOS statischen RAM-Zelle nach Anspruch 5 mit zwei PNP-Transistoren, wobei die Emitter-Elektroden des einen Transistors mit der Emitter-Elektrode eines der genannten Bipolartransistoren verbunden ist und die Emitter-Elektrode des anderen mit der Emitter-Elektrode des anderen Bipolartransistors verbunden ist, wobei die Kollektor-Elektroden der PNP-Transistoren mit einer niedrigen Spannung verbunden sind und wobei die Basis-Elektroden der genannten PNP-Transistoren zum Erhalten geeigneter Schreibsignale vorgesehen sind.

## Revendications

1. Cellule de circuit intégré CMOS RAM statique comportant un substrat en matériau semiconducteur d'un premier type de conductivité, une région en matériau semiconducteur d'un second type de conductivité, située dans ledit substrat et formant dans celui-ci un puits ayant une surface, une pluralité de régions en matériau semiconducteur dudit premier type de conductivité situées dans ledit puits et formant des zones de source et de drain de transistors à effet de champ qui forment deux transistors de stockage de données avec des électrodes de grille couplées en croix de la cellule de mémorisation, caractérisée en ce que dans ledit puits, sont situées six régions en matériau semiconducteur dudit premier type de conductivité formant dans celui-ci six poches arrangées en deux jeux de trois poches, les première et troisième poches de chaque jeu étant séparées de la deuxième poche suivant la surface dudit puits par quatre parties dudit matériau de puits, une couche mince d'oxyde située sur lesdites quatre parties dudit matériau de puits et formant des couches isolantes, des électrodes de grille situées sur lesdites quatre couches isolantes, lesdites électrodes de grille et lesdites six poches comportant quatre transistors à effet de champ, lesdits deux transistors de stockage de données et deux transistors d'accès, une région en matériau semiconducteur dudit second type de conductivité ètant située dans l'une des poches de chaque jeu, région qui comporte l'émetteur d'un transistor bipolaire dont la base est formée par la poche où cette région est située, le collecteur dudit transistor bipolaire associé étant constitué par ledit puits.

2. Cellule de circuit intégré CMOS RAM statique selon la revendication 1, dans laquelle ledit matériau semiconducteur du premier type de conductivité est un matériau de type P et ledit matériau semiconducteur du second type de conductivité est un matériau de type N.

3. Cellule de circuit intégré CMOS RAM statique selon la revendication 2, dans laquelle les régions de source desdits transistors de stockage de données sont reliées entre elles et la région de drain de l'un de ces transistors de stockage de données est reliée à l'électrode de grille de l'autre transistor de stockage de données.

4. Cellule de circuit intègré CMOS RAM statique selon la revendication 3, dans laqeulle la région de source de l'un desdits transistors d'accès est reliée à l'électrode de grille de l'un des transistors de stockage de données et la région de source de l'autre transistor d'accès est reliée à l'électrode de grille de l'autre transistor de stockage de données, et dans laquelle la région de drain de l'un desdits transistors d'accès est reliée à la base de l'un desdits transistors bipolaires et la région de drain de l'autre transistor d'accès est reliée à la base de l'autre transistor bipolaire.

5. Cellule de circuit intégré CMOS RAM statique selon la revendication 4, dans laquelle les collecteurs desdits transistors bipolaires sont reliés entre eux et les émetteurs sont reliés aux sorties de ladite cellule de mémorisation.

6. Cellule de circuit intégré CMOS RAM statique selon la revendication 5, comportant deux transistors de type PNP, l'émetteur de l'un des ces transistors étant relié à l'émetteur de l'un desdits transistors bipolaires et l'émetteur de l'autre transistor de type PNP étant relié à l'émetteur de l'autre transistor bipolaire, transistors PNP dont les collecteurs sont raccordés à une tension basse et dont les bases servant à recevoir des signaux d'écriture convenables.

**FIG.1**

**FIG.2**

**FIG.3**